# FASCICULE DE BREVET EUROPEEN

(11) **EP 3 329 417 B1**
(45) Date de publication et mention de la délivrance du brevet: **08.04.2020**
(21) Numéro de dépôt: 16744411.6
(22) Date de dépôt: 28.07.2016
(51) Int. Cl.: G06K 19/077, G06K 7/10

(54) **DISPOSITIF DE TRAITEMENT POUR PUCES ÉLECTRONIQUES D'UN ÉLÉMENT ALLONGÉ**
BEHANDLUNGSVORRICHTUNG FÜR ELEKTRONISCHE CHIPS EINES LÄNGLICHEN ELEMENTS
TREATMENT DEVICE FOR ELECTRONIC CHIPS OF AN ELONGATE ELEMENT

(30) Priorité: 31.07.2015 FR 1557423
(43) Date de publication de la demande: 06.06.2018
(73) Titulaire: Commissariat à l'Énergie Atomique et aux Énergies Alternatives, 75015 Paris (FR)
(72) Inventeur: MARNAT, Loïc, 38100 Grenoble (FR); DUSSOPT, Laurent, 38100 Grenoble (FR); VICARD, Dominique, 38190 Bernin (FR)
(74) Mandataire: Novaimo
(86) Numéro de dépôt international: PCT/EP2016/067967
(87) Numéro de publication internationale: WO 2017/021264

(56) Documents cités:
- WO-A1-03/071476
- US-A- 6 104 291
- US-A1- 2009 237 221

## Description

### Domaine technique de l'invention

L'invention concerne le domaine du traitement des puces électroniques, et notamment du test de radio-étiquettes, par exemple intégrées à un fil.

L'invention a pour objet plus particulièrement un dispositif de traitement pour élément allongé muni d'une pluralité de puces électroniques échelonnées selon la longueur dudit élément allongé.

### État de la technique

Dans le domaine de l'électronique, et plus particulièrement des radio-étiquettes, il est usuel de fabriquer des puces électroniques communicantes, puis de les tester individuellement pour s'assurer de leur bon fonctionnement. Ces tests permettent notamment d'effectuer un tri quant à la qualité des radio-étiquettes, tout en autorisant leur écriture pour les initialiser.

En particulier, les documents US2008/0100329 et WO2013/144451 décrivent l'utilisation d'une cavité ouverte dans laquelle une antenne est disposée. Lorsqu'une radio-étiquette passe au dessus de la cavité, elle coopère avec l'antenne d'un système de test disposée dans le fond de la cavité.

Il en résulte une problématique lors de tests à grande cadence. En effet, dans ce cas les radio-étiquettes sont relativement proches les unes des autres, ainsi le test d'une radio-étiquette en particulier par l'antenne disposée dans la cavité risque de perturber les radio-étiquettes adjacentes. En ce sens, le document US2008/0100329 propose de mettre à la terre les radio-étiquettes non testées. Cette solution est complexe à mettre en oeuvre dans le sens où il faut prévoir de mettre à la masse toutes les radio-étiquettes à portée de l'antenne.

Le document WO2013/144451 propose quant à lui d'utiliser un coupleur capacitif permettant de minimiser les influences extérieures. En ce sens, cette solution, qui propose une simple minimisation des influences, demande à être améliorée.

Le document US6104291 décrit un procédé et un appareil de test de radio-étiquettes. Le document US2009/237221 décrit une solution pour programmer des étiquettes. Le document WO03/071476 décrit un procédé de fabrication d'un transpondeur.

### Objet de l'invention

Le but de la présente invention est de proposer une solution qui remédie aux inconvénients listés ci-dessus.

On tend vers ce but grâce à un dispositif de traitement apte à coopérer avec un élément allongé muni d'une pluralité de puces électroniques échelonnées selon la longueur dudit élément allongé, ledit dispositif de traitement comprenant un boîtier comportant :
- un orifice d'entrée pour l'élément allongé,
- un orifice de sortie pour l'élément allongé,
- une cavité de traitement disposée entre l'orifice d'entrée et l'orifice de sortie et munie d'une sonde de traitement pour puce électronique,
et le dispositif de traitement comportant un système d'isolement configuré pour isoler une puce électronique à traiter présente dans la cavité d'autres puces électroniques de la pluralité de puces électroniques disposées à l'extérieur de la cavité, ce système d'isolement comportant des éléments de mise en court-circuit configurés de sorte à venir en contact physique avec l'élément allongé de part et d'autre d'une puce à traiter placée dans la cavité.

En particulier, la sonde de traitement comporte une antenne radiofréquence configurée pour interagir avec la puce électronique à traiter formant une puce d'une radio-étiquette.

Avantageusement, l'antenne est choisie parmi :
- une antenne dipolaire,
- une antenne à fente unique dont ladite fente unique s'étend le long d'un tronçon de l'élément allongé présent dans la cavité du boîtier lorsque l'élément allongé traverse l'orifice d'entrée et l'orifice de sortie,
- une antenne à double fentes dont une première fente s'étend le long d'un tronçon de l'élément allongé présent dans la cavité du boîtier lorsque l'élément allongé traverse l'orifice d'entrée et l'orifice de sortie, et dont une deuxième fente est sensiblement perpendiculaire à la première fente, lesdites première et deuxième fentes étant incluses dans un même plan et comprenant une partie commune au niveau de leur intersection,
- une antenne boucle.

Selon une réalisation, le système d'isolement comporte une première ferrite disposée au niveau de l'orifice d'entrée et une deuxième ferrite disposée au niveau de l'orifice de sortie.

Alternativement ou en combinaison avec les ferrites, le système d'isolement peut comporter des éléments de mise en court-circuit configurés de sorte à venir en contact physique avec l'élément allongé de part et d'autre d'une puce à traiter placée dans la cavité.

L'invention est aussi relative à une installation comprenant un dispositif de traitement tel que décrit, un élément allongé comportant une pluralité de puces électroniques échelonnées selon la longueur dudit élément allongé, un système d'entrainement de l'élément allongé pour le faire défiler au travers du boîtier du dispositif de traitement par les orifices d'entrée et de sortie, l'installation comprenant une configuration de traitement dans laquelle une puce électronique à traiter de l'élément allongé est présente dans la cavité du boîtier et dans laquelle deux puces électroniques adjacentes à la puce électronique à traiter sont disposées hors du boîtier.

Notamment, dans la configuration de traitement, les deux puces électroniques adjacentes à la puce électronique à traiter sont reliées électriquement à la puce à traiter par des éléments de liaison de l'élément allongé, et le système d'isolement est configuré pour agir sur les ondes électromagnétiques issues de la sonde de traitement se propageant le long desdits éléments de liaison reliés à ladite puce électronique à traiter.

En particulier, dans la configuration de traitement, lesdits éléments de liaison traversent chacun une ferrite.

Les éléments de liaison peuvent être en contact physique avec des éléments de mise en court-circuit du système d'isolement.

L'invention est aussi relative à un procédé d'utilisation d'un dispositif tel que décrit comprenant :
- une étape de fourniture d'un élément allongé comportant une pluralité de puces électroniques échelonnées selon la longueur dudit élément allongé,
- une étape de placement de l'une des puces de la pluralité de puces électroniques dans la cavité du dispositif de traitement de telle sorte que deux autres puces électroniques adjacentes de la puce électronique placée dans la cavité soient disposées à l'extérieur du boîtier,
- une étape d'activation de la sonde de traitement pour traiter ladite puce électronique placée dans la cavité d'où il résulte que la sonde de traitement interagit avec la puce électronique placée dans la cavité.

La puce électronique placée dans la cavité et les deux puces électroniques adjacentes placées hors du boîtier au cours de l'étape de placement sont des puces électroniques de radio-étiquettes, et la puce électronique placée dans la cavité est reliée électriquement à l'une des puces électroniques adjacentes par un premier élément de liaison électrique, et à l'autre des puces électroniques adjacentes par un deuxième élément de liaison électrique, les premier et deuxième éléments de liaison électrique formant une antenne de la puce électronique placée dans la cavité, et le procédé comporte une étape d'interaction du système d'isolement avec les premier et deuxième éléments de liaison électrique permettant de filtrer, ou de court-circuiter, des ondes électromagnétiques se propageant long des premier et deuxième éléments de liaison électrique consécutivement à l'activation de la sonde de traitement pour éviter l'alimentation électrique desdites deux puces électroniques adjacentes par lesdites ondes électromagnétiques.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 illustre un premier type d'élément allongé,
- la figure 2 illustre un deuxième type d'élément allongé,
- la figure 3 illustre plus en détails l'intégration des puces électroniques au sein de l'élément allongé du type de la figure 1,
- la figure 4 illustre une vue en perspective d'un dispositif de traitement selon une mise en oeuvre particulière de l'invention,
- la figure 5 est une vue en coupe du boîtier de la figure 4 dans une réalisation où le système d'isolement est à base de ferrites,
- la figure 6 est une vue en coupe d'un boîtier du type de la figure 4 dans une variante où le système d'isolement est à base d'éléments de court-circuits,
- la figure 7 illustre une réalisation particulière dans laquelle la sonde de traitement comporte une antenne dipolaire,
- la figure 8 illustre une réalisation particulière dans laquelle la sonde de traitement est une antenne à simple fente,
- la figure 9 illustre une réalisation particulière dans laquelle la sonde de traitement est une antenne à double fentes,
- la figure 10 illustre un exemple particulier d'une installation comprenant un dispositif de traitement selon une mise en oeuvre particulière de l'invention,
- la figure 11 illustre la puissance de rétrodiffusion en fonction de la puissance transmise pour une sonde de traitement de radio-étiquette sans l'utilisation du boîtier de traitement,
- la figure 12 illustre la puissance de rétrodiffusion en fonction de la puissance transmise pour une sonde de traitement de radio-étiquette avec l'utilisation du boîtier de traitement,
- le figure 13 illustre encore une autre réalisation particulière dans laquelle la sonde de traitement est une antenne boucle,
- la figure 14 illustre une variante de la figure 10 dans le sens où l'installation comporte deux dispositifs de traitement.

### Description de modes préférentiels de l'invention

La présente invention diffère de l'art antérieur notamment en ce qu'elle propose d'utiliser un boîtier permettant d'isoler et de traiter/tester une puce électronique individuellement, par exemple en agissant sur le confinement des ondes émises par une sonde de traitement dans l'exemple de puce de radio-étiquette.

Bien que la présente invention soit préférentiellement applicable au domaine du traitement des radio-étiquettes, notamment de leur test, la puce à traiter par le dispositif de traitement peut être d'autre type comme une diode électroluminescente ou une cellule photovoltaïque.

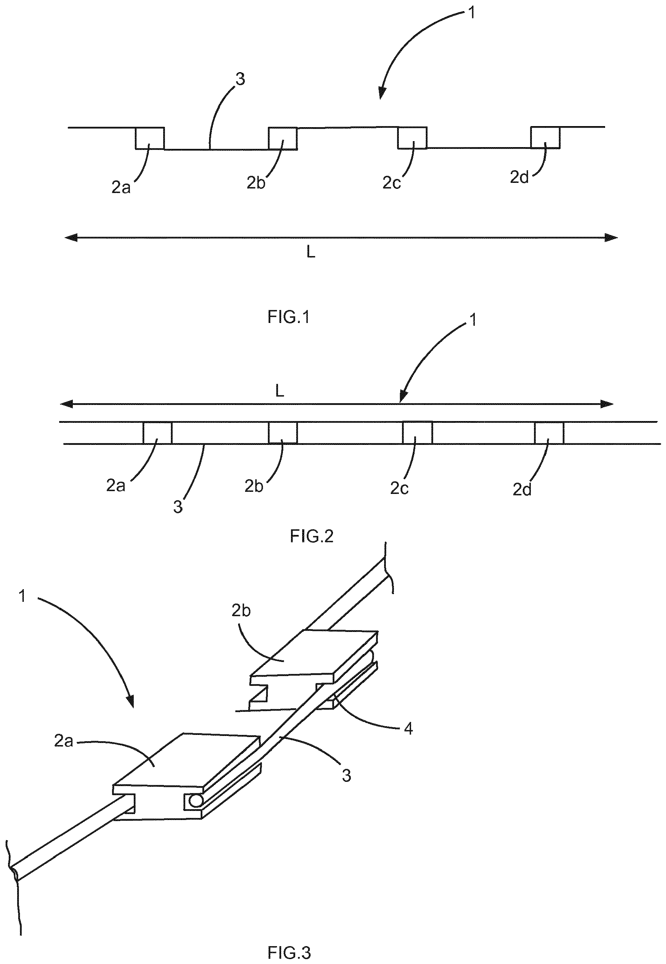

Dans la présente description, comme illustré aux figures 1 et 2, un élément allongé 1 comporte une pluralité de puces électroniques 2a, 2b, 2c, 2d échelonnées selon la longueur L dudit élément allongé 1. Des éléments de liaison 3 de l'élément allongé 1 permettent de relier mécaniquement deux à deux les puces électroniques 2a, 2b, 2c, 2d.

Typiquement, hormis les deux puces électroniques 2a, 2d de la pluralité de puces électroniques 2a, 2b, 2c, 2d situées aux extrémités longitudinales opposées de l'élément allongé 1, chaque puce électronique 2b, 2c est encadrée par deux autres puces électroniques adjacentes respectivement appelées puce électronique précédente et puce électronique suivante. Par exemple, la puce électronique encadrée 2b est reliée à la puce électronique précédente 2a par un premier élément de liaison et à la puce électronique suivante 2c par un deuxième élément de liaison.

Ainsi, dans la présente description, on entend par « puce électronique adjacente d'une autre puce électronique », une puce électronique qui se situe directement à côté d'une autre puce électronique sans interposition de puce électronique intermédiaire.

Dans la présente description, une puce ou une puce à traiter, est une puce électronique.

Sur l'exemple de la figure 1, les puces électroniques 2a, 2b, 2c, 2d forment trois couples de puces électroniques adjacentes (2a, 2b) (2b, 2c) (2c, 2d) et les puces électroniques de chaque couple de puces électroniques adjacentes sont reliées par un unique élément de liaison qui leur est associé.

Sur l'exemple de la figure 2, les puces électroniques 2a, 2b, 2c, 2d forment trois couples de puces électroniques adjacentes (2a, 2b) (2b, 2c) (2c, 2d) et les puces électroniques de chaque couple de puces électroniques adjacentes sont reliées par deux éléments de liaison 3 qui leur sont associés.

Dans l'exemple de la figure 2, les puces électroniques peuvent être maintenues entre deux fils dont des tronçons sont formés par des éléments de liaisons.

Notamment, l'élément allongé 1 de la figure 2 peut être un produit intermédiaire permettant l'obtention de l'élément allongé 1 selon la figure 1. Dans ce cas, on comprend que certains tronçons des deux fils pourront être coupés de manière idoine.

Les éléments de liaison permettent de relier mécaniquement les puces électroniques entre elles pour que l'élément allongé forme une guirlande de puces électroniques.

Selon une mise en œuvre particulière, les éléments de liaison 3 sont en toute ou partie électriquement conducteurs, et chaque puce électronique 2a, 2b, 2c, 2d de la pluralité de puces électroniques est connectée électriquement à au moins deux éléments de liaison, notamment s'étendant de part et d'autre de ladite puce électronique selon la longueur de l'élément allongé, pour former une radio-étiquette. Autrement dit, chaque puce électronique de la pluralité de puces électroniques peut être une puce d'une radio-étiquette dont l'antenne est formée par au moins deux éléments de liaison électriquement conducteurs. Par « élément de liaison électriquement conducteur », on entend que l'élément de liaison peut comporter une âme électriquement conductrice recouverte ou non d'un isolant. Ainsi, outre la liaison mécanique entre les puces électroniques de l'élément allongé 1, les éléments de liaison permettent aussi de relier les puces électroniques électriquement entre elles.

Une radio-étiquette, ou Tag RFID (de l'anglais « Radio Frequency Identification ») est généralement utilisée pour mémoriser ou récupérer des données à distance. Par exemple, une radio-étiquette permet d'identifier des objets ou encore des personnes porteuses d'un objet associé à une radio-étiquette. Un lecteur au sens de la présente description permet d'écrire et/ou de lire des informations de la radio-étiquette.

En particulier, les radio-étiquettes de l'élément allongé sont de type UHF « Ultra Haute Fréquence », c'est-à-dire dont la bande de fréquence peut être comprise entre 860MHz et 960MHz.

Dans l'exemple où les puces électroniques sont des puces de radio-étiquettes, les puces électroniques peuvent être espacées de quelques centimètres, typiquement entre 8cm et 16cm. Cette distance d'espacement est proportionnelle au quart ou à la demi-longueur d'onde des radio-étiquettes.

La figure 3 montre un exemple d'intégration des puces électroniques à l'élément allongé 1 applicable aux différentes réalisations de l'élément allongé 1. Ici les puces électroniques 2a, 2b comprennent un support muni d'au moins une rainure 4 d'encastrement longitudinal d'un élément de liaison associé. La figure 3 montre que chaque puce électronique comporte au moins deux rainures 4 d'encastrement et dans chaque rainure d'encastrement 4 un élément de liaison 3 correspondant est encastré. Ce principe peut aussi être utilisé pour former l'élément allongé selon la figure 2 dans le sens où chaque puce électronique encastre alors les deux fils dans deux rainures d'encastrement longitudinales correspondantes.

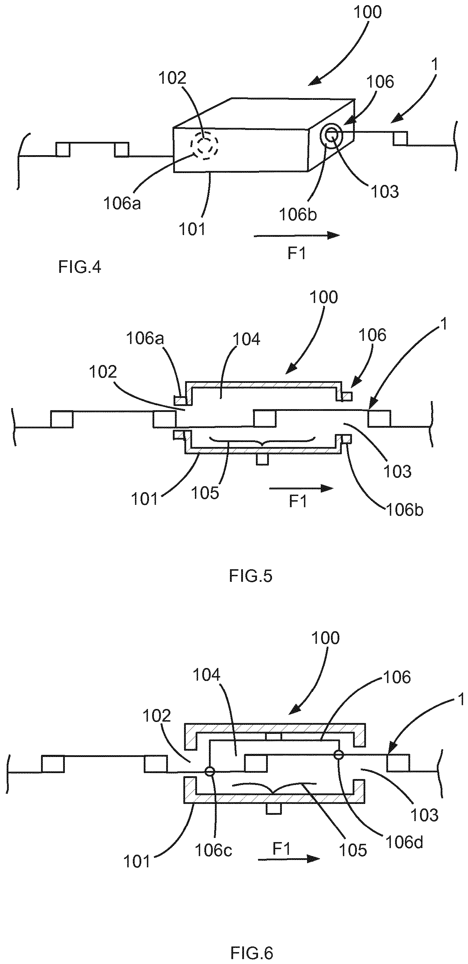

Les figures 4 à 6 illustrent un dispositif de traitement 100 apte à coopérer avec l'élément allongé décrit précédemment. Ce dispositif de traitement 100 comprend un boîtier 101 comportant un orifice d'entrée 102 pour l'élément allongé 1 et un orifice de sortie 103 pour l'élément allongé 1. On comprend alors que le boîtier 100 est configuré de sorte à autoriser en son sein le défilement de l'élément allongé 1 selon un sens orienté par la flèche F1.

En outre, le dispositif de traitement comporte une cavité de traitement 104 disposée entre l'orifice d'entrée 102 et l'orifice de sortie 103 et munie d'une sonde de traitement 105 pour puce électronique. Autrement dit, la sonde de traitement 105 est placée dans la cavité 104. L'orifice d'entrée 102 permet à une puce électronique de l'élément allongé 1 de pénétrer dans la cavité et l'orifice de sortie 103 permet d'extraire ladite puce après son traitement dans la cavité 104. Autrement dit, les orifices d'entrée et de sortie 102, 103 mettent en communication la cavité 104 du boîtier 101 avec l'extérieur du boîtier 101. On comprend alors que la cavité 104 est interne au boîtier 101, nonobstant les orifices d'entrée et de sortie qui permette la mise en communication de l'intérieur de la cavité 104 avec l'extérieur du boîtier 101, la cavité 104 est une cavité fermée.

Enfin le dispositif de traitement 100, préférentiellement le boîtier 101 du dispositif de traitement 100, comprend un système d'isolement 106 configuré pour isoler une puce électronique à traiter présente dans la cavité 104 d'autres puces électroniques de la pluralité de puces électroniques disposées à l'extérieur de la cavité 104.

Plus particulièrement, le système d'isolement 106 permet d'éviter que la sonde de traitement 105 ne puisse interagir avec les puces électroniques situées à l'extérieur du boîtier 101, ou avec l'environnement extérieur du boîtier 101.

Selon un exemple, les puces électroniques sont des diodes électroluminescentes, ou des cellules photovoltaïques, et le boîtier combiné au système d'isolement permet de traiter (notamment de tester) au mieux lesdites puces électroniques de manière individuelle sans que l'environnement extérieur au boîtier n'influe, le cas échéant, sur la puce électronique traitée ou sur la sonde de traitement.

Selon une réalisation préférée évoquée précédemment, les puces de la pluralité de puces électroniques sont des puces de radio-étiquettes. En ce sens, la sonde de traitement 105 comporte une antenne radiofréquence configurée pour interagir avec la puce électronique à traiter (c'est-à-dire une puce électronique présente dans la cavité du boîtier) formant une puce d'une radio-étiquette. Dans ce cas, le boîtier 101 peut être formé de telle manière à contenir les ondes électromagnétiques générées par l'antenne de la sonde de traitement 105 au sein du boîtier 101 pour éviter que ces ondes atteignent les puces de l'élément allongé 1 situées à l'extérieur du boîtier 101 et ne provoque leur réveil/alimentation électrique.

Lorsque les puces électroniques de l'élément allongé forment des puces de radio-étiquettes, la sonde de traitement 105 est notamment reliée à un lecteur de radio-étiquettes. Un tel lecteur pour traiter, tester et/ou écrire et/ou lire des radio-étiquettes est bien connu de l'homme du métier et ne sera pas décrit ici.

Le système d'isolement 106 peut aussi participer à éviter ou à limiter la propagation des ondes issues de la sonde de traitement 105 hors du boîtier 101. Ceci est notamment le cas lorsque le boîtier 101 est utilisé pour traiter un élément allongé 1 comportant une pluralité de radio-étiquettes chacune formée par une puce électronique correspondante et par une antenne formée à partir des éléments de liaison reliant électriquement deux puces électroniques adjacentes de l'élément allongé. On comprend ici que lorsqu'une puce à traiter est présente dans la cavité, la sonde de traitement 105 va aussi interagir par couplage d'ondes avec les éléments de liaison qui risquent alors de propager les ondes à l'extérieur du boîtier 101 via les orifices d'entrée et de sortie 102, 103. La présence du système d'isolement 106 permet de stopper (ou de limiter) cette propagation à partir des éléments de liaison.

En ce sens, le système d'isolement 106 peut comporter (figures 4 et 5) une première ferrite 106a disposée au niveau de l'orifice d'entrée 102 et une deuxième ferrite 106b disposée au niveau de l'orifice de sortie 103. Ces ferrites 106a, 106b permettent alors de contenir les ondes au niveau du boîtier 101 et d'empêcher que ces dernières n'atteignent les puces électroniques situées à l'extérieur du boîtier 101. Par «au niveau de l'orifice d'entrée », on entend que la première ferrite 106a peut être placée à l'extérieur de la cavité 104 comme cela est visible à la figure 5, mais qu'alternativement la première ferrite 106a peut être placée à l'intérieur de la cavité 104. Par « au niveau de l'orifice de sortie » on entend que la deuxième ferrite 106b peut être placée à l'extérieur de la cavité 104 comme cela est visible à la figure 5, mais qu'alternativement la deuxième ferrite 106b peut être placée à l'intérieur de la cavité 104. Par exemple, les ferrites 106a, 106b forment un filtre d'atténuation des ondes se propageant dans les éléments de liaison consécutivement à l'activation de la sonde de traitement 105 pour abaisser les niveaux des ondes se propageant dans les éléments de liaison à des niveaux inaptes à réveiller une radio-étiquette à l'extérieur du boîtier 101. En particulier, chacune des première et deuxième ferrites 106a, 106b comprend une ouverture, et est traversée par l'élément allongé. L'ouverture des ferrites 106a, 106b se situe donc dans le prolongement respectivement des orifices d'entrée et de sortie 102, 103. L'avantage d'utiliser un système d'isolement 106 à base de ferrites est que le système d'isolement 106 n'a pas à venir en contact avec l'élément allongé 1 pour réaliser sa fonction de filtre, il en résulte que la cadence de traitement peut être augmentée. L'homme du métier sera à même de choisir les ferrites adaptées connaissant les caractéristiques des radio-étiquettes et de la puissance d'émission de la sonde de traitement. En effet, les matériaux formant les ferrites se caractérisent par une perméabilité (notée µ) supérieure à 1. Ces matériaux concentrent le champ magnétique et sont souvent utilisés soit pour atténuer des courants conduits sur un câble d'alimentation, soit pour coupler de l'énergie (transformateur). Selon un exemple particulier adapté à l'application d'un mode particulier de la présente invention, les ferrites sont choisies sur la base des données constructeurs présentant l'impédance en fonction de la fréquence, ici on choisira préférentiellement des ferrites dont la résistance est d'environ 1000 ohms à 1GHz.

Le système d'isolement 106 à base de ferrites 106a, 106b est tout particulièrement adapté pour un élément allongé du type de la figure 1 et permet un isolement sans contact avec l'élément allongé 1 au cours de son défilement dans le boîtier 101.

Avantageusement, la distance entre la ferrite et la guirlande est faible, de préférence inférieure ou égale à 5 mm. De plus, il est aussi intéressant que la ferrite s'étende sur une longueur significative le long de la guirlande, de préférence sur une longueur supérieure ou égale à 10 mm.

La figure 6 illustre une autre mise en œuvre du système d'isolement 106. Ici, le système d'isolement 106 permet de réaliser une mise en court-circuit des éléments de liaison de part et d'autre de la puce électronique à traiter afin de confiner les ondes émise par la sonde de traitement 105 et couplées aux éléments de liaison dans la cavité 104. Autrement dit, le système d'isolement 106 peut comporter des éléments de mise en court-circuit 106c, 106d configurés de sorte à venir en contact physique avec l'élément allongé 1 de part et d'autre d'une puce à traiter placée dans la cavité 104. Les éléments de mise en court-circuit peuvent être disposés au niveau des orifices d'entrée et de sortie du boîtier 101. Selon un exemple, les éléments de mise en court-circuit 106c, 106d comportent des bornes de connexion formées dans l'orifice d'entrée et l'orifice de sortie, dans ce cas, l'élément allongé 1 peut être sollicité contre lesdites bornes de connexion lorsqu'une puce à traiter est présente dans la cavité 104 ou au cours du défilement de l'élément allongé 1 dans le boîtier 101. Selon une réalisation, les éléments de mise en court-circuit peuvent être mis en œuvre par deux galets de guidage en contact avec l'élément allongé de part et d'autre de la puce à traiter lorsque cette dernière est disposée dans la cavité du boîtier, notamment ces galets peuvent guider l'élément allongé 1 lorsqu'il traverse la cavité. Selon encore une autre réalisation, les éléments de mise en court-circuit peuvent être mis en œuvre par des brosses de type antistatique disposées respectivement au niveau des orifices d'entrée et de sortie du boîtier de telle manière à toucher l'élément allongé de part et d'autre de la puce à traiter lorsque cette dernière est disposée dans la cavité.
Le mode de réalisation de la figure 6 est tout particulièrement adapté à l'élément allongé 1 de la figure 2, bien qu'il soit aussi fonctionnel avec le mode de réalisation de la figure 1. En effet, dans le cadre d'un élément allongé 1 selon la figure 2, le champ électromagnétique se confine entre deux éléments de liaison parallèles et placés en regard ce qui implique que la ferrite n'est pas suffisante. La mise en court-circuit permet alors de contrôler la propagation de l'onde électromagnétique en l'empêchant de se propager jusqu'aux puces électroniques adjacentes de la puce électronique en cours de traitement disposées à l'extérieur du boîtier 1.

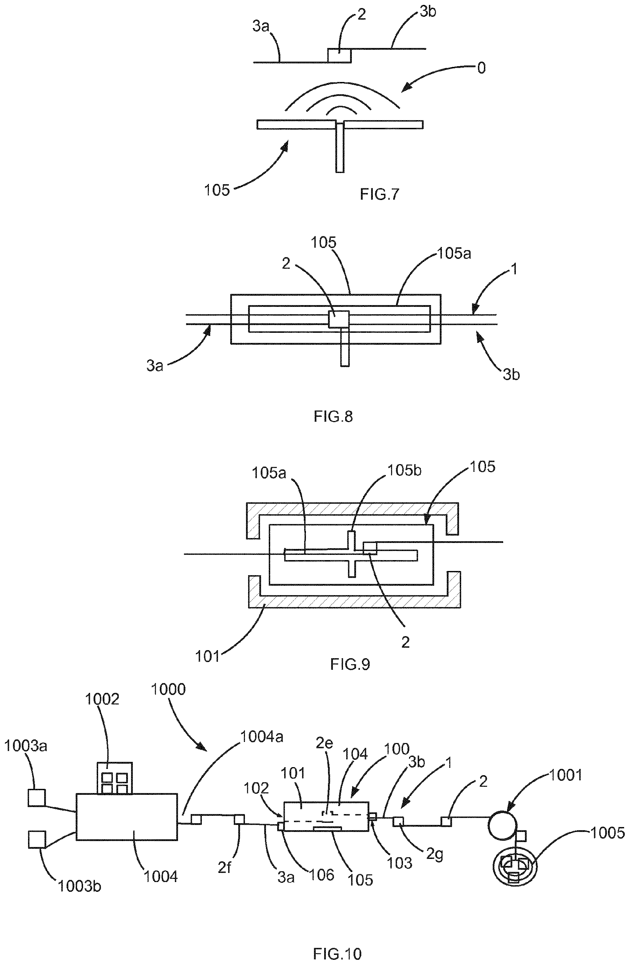

Selon une mise en œuvre, lorsque la sonde de traitement 105 est destinée à coopérer avec une radio-étiquette dont la puce 2 est reliée électriquement à seulement deux éléments de liaison électriquement conducteurs 3a, 3b, la sonde de traitement 105 peut comporter une antenne se présentant sous la forme d'un simple dipôle (antenne dipolaire) comme le montre la figure 7. Dans ce cas, les ondes O générées par l'antenne se propage jusqu'à la radio-étiquette de manière connue.

Lorsque la radio-étiquette est intégrée à un élément allongé selon la figure 2, la sonde de traitement 105 comporte avantageusement une antenne (figure 8) comportant une fente 105a parallèle à l'élément allongé 1 lorsqu'une puce électronique 2 doit être traitée. Ceci permet à l'antenne 105 de se coupler avec deux couples d'éléments de liaison parallèles 3a, 3b reliés de part et d'autre à la puce 2 de la radio-étiquette à traiter.

Alternativement, comme illustré en figure 9, pour que la sonde de traitement 105 puisse être compatible à la fois avec l'élément allongé 1 de la figure 1 et l'élément allongé 1 de la figure 2, ladite sonde de traitement 105 peut comporter une antenne à doubles fentes 105a, 105b sensiblement perpendiculaires dont l'une des fentes est sensiblement parallèle à l'élément allongé lors de son défilement dans le boîtier 101 (compatibilité avec l'élément allongé 1 du type de la figure 2) et l'autre des fentes est sensiblement perpendiculaire à l'élément allongé lors de son défilement dans le boîtier 101 (compatibilité avec l'élément allongé du type de la figure 1). Dans ce cas, les deux fentes 105a, 105b ont une partie commune au niveau de leur intersection et un lecteur peut être relié aux deux fentes au niveau de leur intersection.

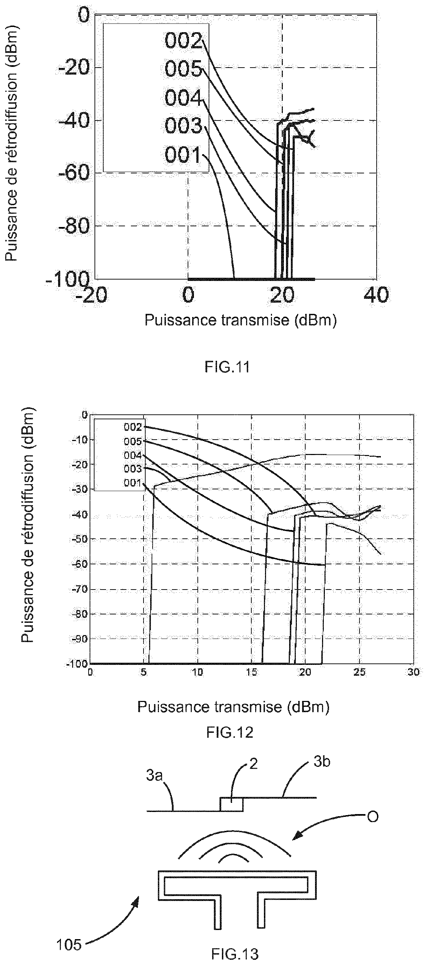

Autrement dit, l'antenne de la sonde de traitement peut être choisie parmi :
- une antenne dipolaire 105,
- une antenne 105 à fente unique 105a dont ladite fente unique s'étend le long d'un tronçon de l'élément allongé 1 présent dans la cavité 104 du boîtier 101 lorsque l'élément allongé 1 traverse l'orifice d'entrée 102 et l'orifice de sortie 103,
- une antenne 105 à double fentes 105a, 105b dont une première fente 105a s'étend le long d'un tronçon de l'élément allongé 1 présent dans la cavité 104 du boîtier 101 lorsque l'élément allongé 1 traverse l'orifice d'entrée 102 et l'orifice de sortie 103, et dont une deuxième fente 105b est sensiblement perpendiculaire à la première fente 105a, lesdites première et deuxième fentes 105a, 105b étant incluses dans un même plan et comprenant une partie commune au niveau de leur intersection. Un lecteur peut être relié auxdites fentes au niveau de leur intersection,
- une antenne 105 boucle telle qu'illustrée en figure 13 et utilisant les mêmes références que la figure 7.

Cette liste d'antennes de la sonde de traitement peut être étoffée en fonction de l'utilisation du dispositif de traitement.

L'invention est aussi relative à une installation 1000 visible en figure 10 et comprenant un dispositif de traitement 100 tel que décrit et l'élément allongé 1 comportant la pluralité de puces électroniques 2 échelonnées selon la longueur dudit élément allongé 1. L'installation comporte en outre un système d'entrainement 1001 de l'élément allongé 1 pour le faire défiler au travers du boîtier 101 du dispositif de traitement par les orifices d'entrée et de sortie 102, 103. Le système d'entrainement 1001 peut permettre d'amener successivement les puces électroniques de l'élément allongé 1 dans la cavité pour qu'elles y soient traitée. L'installation 1000 comprend une configuration de traitement dans laquelle une puce électronique à traiter 2e de l'élément allongé 1 est présente dans la cavité 104 du boîtier 101 et dans laquelle deux puces électroniques adjacentes 2f, 2g à la puce électronique à traiter 2e sont disposées hors du boîtier 101.

Dans la configuration de traitement, les deux puces électroniques adjacentes 2f, 2g à la puce électronique à traiter 2e peuvent être reliées électriquement à la puce à traiter 2e par des éléments de liaison 3a, 3b de l'élément allongé 1, et le système d'isolement 106 est configuré pour agir sur les ondes électromagnétiques issues de la sonde de traitement 105 se propageant le long des éléments de liaison 3a, 3b reliés à ladite puce électronique 2e à traiter. Dans ce cas les puces électroniques à traiter et adjacentes peuvent être des puces de radio-étiquettes et les éléments de liaison 3a, 3b des antennes de la radio-étiquette à traiter et des antennes des deux puces adjacentes.

Avantageusement, dans la configuration de traitement, lesdits éléments de liaison 3a, 3b (s'étendant de part et d'autre de la puce à traiter 2e) traversent chacun une ferrite. Ainsi, les ferrites permettent de filtrer les ondes issues de la sonde de traitement se propageant le long des éléments de liaison 3a, 3b en direction des deux puces électroniques adjacentes afin de ne pas provoquer leur réveil ou leur alimentation électrique.

Alternativement ou en combinaison avec l'utilisation de ferrites, lesdits éléments de liaison 3a, 3b peuvent être en contact physique avec des éléments de mise en court-circuit du système d'isolement 106, notamment tels que décrit précédemment. Cette mise en court-circuit provoque les effets déjà décrits ci-avant.

Par ailleurs, l'installation peut aussi comporter un réservoir 1002 de puces électroniques ainsi que deux bobines 1003a, 103b de fils reliés à une machine d'assemblage 1004 permettant de fournir à sa sortie 1004a l'élément allongé 1 tel que décrit précédemment. Par exemple, pour cela, l'installation peut comporter un dispositif d'assemblage de puces électroniques sur un fil tel que décrit dans le document EP2390194.

Enfin, après le boîtier 101, l'installation 1000 peut comporter un système d'enroulement 1005 de l'élément allongé 1.

En outre, l'invention est aussi relative à un procédé d'utilisation d'un dispositif de traitement tel que décrit. Un tel procédé comprend : une étape de fourniture d'un élément allongé 1 comportant une pluralité de puces électroniques échelonnées selon la longueur dudit élément allongé 1 ; une étape de placement de l'une 2e des puces électronique de la pluralité de puces électroniques dans la cavité 104 du dispositif de traitement 101 de telle sorte que deux autres puces électroniques adjacentes 2f, 2g de la puce électronique 2e (la puce électronique à traiter) placée dans la cavité 104 soient disposées à l'extérieur du boîtier 101 ; une étape d'activation de la sonde de traitement 105 pour traiter ladite puce électronique 2e placée dans la cavité 104 d'où il résulte que la sonde de traitement 105 interagit avec la puce électronique 2e placée dans la cavité 104.

En particulier, il peut découler de ce qui a été dit précédemment en relation avec la description de l'installation que la puce électronique 2e placée dans la cavité 104 et les deux puces électroniques adjacentes 2f, 2g placées hors du boîtier 101 au cours de l'étape de placement sont des puces électroniques de radio-étiquettes. Dans ce cas, la puce électronique 2e placée dans la cavité 104 est reliée électriquement à l'une des puces électroniques adjacentes 2f par un premier élément de liaison électrique 3a, et à l'autre des puces électroniques adjacentes 2g par un deuxième élément de liaison électrique 3b, les premier et deuxième éléments de liaison électrique 3a, 3b formant une antenne de la puce électronique 2e placée dans la cavité 104. Ainsi, dans ce cas particulier, le procédé comporte une étape d'interaction du système d'isolement 106 avec les premier et deuxième éléments de liaison 3a, 3b permettant de filtrer, ou de court-circuiter, des ondes électromagnétiques se propageant long des premier et deuxième éléments de liaison 3a, 3b consécutivement à l'activation de la sonde de traitement 105 pour éviter l'alimentation électrique desdites deux puces électroniques adjacentes 2f, 2g par lesdites ondes électromagnétiques.

Comme évoqué précédemment, le boîtier 101 (et notamment la cavité 104) peut être agencé pour confiner les ondes émises par la sonde de traitement 105.

De manière générale, le boîtier est blindé et peut adopter une forme rectangulaire allongée dans le sens de défilement de l'élément allongé entre l'orifice d'entrée 102 et l'orifice de sortie 103. Dans l'exemple des figures 4 à 6, le boîtier 101 est métallique et adopte les dimensions suivantes 11x4x4 cm³. De manière générale, les dimensions du boîtier 101 et notamment de la cavité 104 seront adaptées en fonction de la sonde de traitement 105 et du type de puces à traiter.

De préférence, dans l'application selon laquelle les puces électroniques de l'élément allongé sont des puces électroniques de radio-étiquette, la sonde de traitement 105 est agencée dans la cavité 104 du boîtier 101 de telle sorte que l'antenne de la sonde de traitement 105 soit distante d'une puce électronique à traiter présente dans le boîtier 101 selon une distance comprise entre quelques millimètres et une dizaine de centimètres pour le cas de l'élément allongé 1 selon la figure 1. Pour l'élément allongé 1 selon la figure 2, cette distance séparant l'antenne de la sonde de traitement par rapport à la puce électronique à traiter est de quelques millimètres (par exemple 2mm), notamment comprise entre 0.1 et 5mm.

On comprend de la présente description que le dispositif de traitement peut être avantageusement utilisé lorsque l'élément allongé comprend :
- des radio-étiquettes, ou dispositifs communicants, par liaison UHF filaires interconnectés,
- des radio-étiquettes, ou dispositifs communicants, par liaison UHF filaires non interconnectés mais disposés à distance proche le long d'un fil /câble/corde,
- des radio-étiquettes imprimées sur étiquette et connectées électriquement entre elles.

En outre, le boîtier de traitement peut aussi permettre d'écrire des données au sein des puces électroniques de radio-étiquette permettant ainsi de les fonctionnaliser à la demande. La notion de traitement est à prendre au sens large dans le sens où elle peut permettre de vérifier la fonctionnalité d'une radio-étiquette/d'écrire ou de lire des données sur la radio-étiquette pour la fonctionnaliser de manière indépendante, inscrire des données sur une mémoire de la puce, dialoguer avec la puce, etc. En effet, il a été décrit ci-avant en relation avec le dispositif, l'installation et le procédé, une utilisation selon une fonction générale de traitement. De manière préférée, il peut être considéré une fonction de test qui permet une interaction avec une puce pour par exemple la tester. En ce sens, dans la présente description en relation avec l'invention les occurrences du mot « traitement » peuvent être remplacées par le mot « test », les occurrences du verbe « traiter » par le verbe « tester » et les occurrences du terme « traitée » par le terme « testée ».

De manière générale, un lecteur peut être relié à la sonde de traitement (notamment à l'antenne de la sonde de traitement) pour permettre l'émission d'ondes électromagnétiques par ladite sonde de traitement dans la cavité 104 du boîtier 101. Dans la présente description, l'utilisation du terme « ondes » seul fait notamment référence à ces ondes électromagnétiques.

La figure 11 illustre la puissance de rétrodiffusion en fonction de la puissance transmise par l'antenne pour un test pratiqué sur une radio-étiquette identifiée 003 de l'élément allongé sans l'utilisation du dispositif de traitement. L'élément allongé comporte en outre successivement les radio-étiquettes 001, 002, 003, 004, 005 dont les courbes de réponse sont aussi représentées à la figure 11. On voit que l'onde issue de la sonde de traitement n'est pas confinée au boîtier, et nécessite une puissance de transmission d'environ 20dBm. Il est clair de l'analyse de la figure 11 que le test de la radio-étiquette 003 provoque aussi le réveil des autres radio-étiquettes. A titre de comparaison, la figure 12 illustre la puissance de rétrodiffusion en fonction de la puissance transmise par l'antenne pour l'utilisation du dispositif de traitement dont le système d'isolement comporte les ferrites, et dont la radio-étiquette 003 est présente dans la cavité du boîtier alors que les autres radio-étiquettes 001, 002, 004, 005 sont situées à l'extérieur du boîtier. Il résulte clairement de l'analyse de la figure 12 que le contrôle de la puissance de la sonde de traitement permet de s'assurer que seule la radio-étiquette 003 sera adressée par la sonde de traitement. Par ailleurs, on constate aussi que la puissance nécessaire pour activer une radio-étiquette avec l'utilisation du boîtier est inférieure à la puissance sans boîtier, ceci est dû au fait que les ondes sont confinées dans la cavité. Ainsi, de manière générale, les faces internes de la cavité 4 peuvent être réfléchissantes des ondes émises par la sonde de traitement, ceci pouvant être mis en œuvre lorsque le boîtier est formé par un métal. En ce sens, le dispositif de traitement tel que décrit permet d'utiliser une large gamme de puissance d'émission pour le lecteur relié à la sonde de traitement tout en ayant une sensibilité moindre de l'énergie réfléchie avec une plus grande différence de puissance re-rayonnée entre la radio étiquette sous test (la 003 dans l'exemple) et les autres radio-étiquettes hors du boîtier (001, 002, 004, 005 dans l'exemple).

Ainsi, on comprend de la présente description que le boîtier peut être configuré de sorte à confiner, ou limiter, la propagation des ondes générées par la sonde de traitement hors du boîtier (notamment dans le cadre de test de radio-étiquettes). Pour cela, la cavité formée par le boîtier permet d'éviter une propagation des ondes directement émises par la sonde de traitement hors du boîtier. On parle notamment de boîtier blindé pour assurer cette fonction de confinement. Dès lors le boîtier peut être formé dans un métal et ses caractéristiques peuvent être choisies par l'homme du métier de sorte à assurer sa fonction. En outre, il résulte de l'émission des ondes par la sonde de traitement un couplage desdites ondes à l'élément allongé (notamment aux éléments de liaison électriquement conducteurs) au sein de la cavité et le système d'isolement permet d'empêcher ou de limiter la propagation desdites ondes couplées à l'élément allongé hors du boîtier.

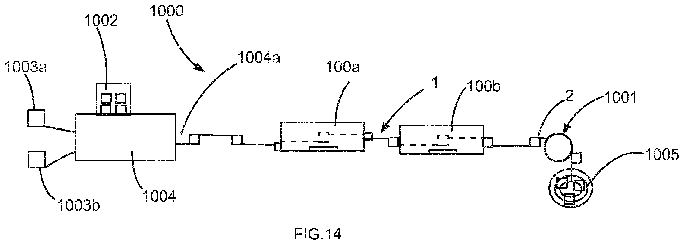

Selon une variante de l'installation illustrée en figure 14, l'installation peut comporter au moins deux dispositifs de traitement 100a, 100b tels que décrits. Les références utilisées à la figure 14 et reprise de la figure 10 représentent des éléments de même type. L'utilisation de plusieurs dispositifs de traitement permet de paralléliser les traitements et d'augmenter la cadence de traitement de l'élément allongé dans sa globalité lorsque qu'un traitement d'une puce électronique impose de ralentir ou de stopper le défilement de l'élément allongé au cours dudit traitement. Selon un autre exemple, un premier dispositif 100a permet de tester une puce de l'élément allongé et un deuxième dispositif 100b permet d'écrire des données sur une puce déjà testée comme fonctionnelle par le dispositif 100a.

## Revendications

1. Dispositif de traitement (100) apte à coopérer avec un élément allongé (1) muni d'une pluralité de puces électroniques (2a, 2b, 2c, 2d) échelonnées selon la longueur dudit élément allongé (1), ledit dispositif de traitement (100) comprenant un boîtier (101) comportant :
- un orifice d'entrée (102) pour l'élément allongé (1),
- un orifice de sortie (103) pour l'élément allongé (1),
- une cavité (104) de traitement disposée entre l'orifice d'entrée (102) et l'orifice de sortie (103) et munie d'une sonde de traitement (105) pour puce électronique,
et le dispositif de traitement comportant un système d'isolement (106) configuré pour isoler une puce électronique à traiter présente dans la cavité (104) d'autres puces électroniques de la pluralité de puces électroniques disposées à l'extérieur de la cavité (104), ce système d'isolement (106) comportant des éléments de mise en court-circuit (106c, 106d) configurés de sorte à venir en contact physique avec l'élément allongé (1) de part et d'autre d'une puce à traiter placée dans la cavité (104).

2. Dispositif selon la revendication précédente, **caractérisé en ce que** la sonde de traitement (105) comporte une antenne radiofréquence configurée pour interagir avec la puce électronique à traiter formant une puce d'une radio-étiquette.

3. Dispositif selon la revendication précédente, **caractérisé en ce que** l'antenne est choisie parmi :
- une antenne dipolaire (105),
- une antenne (105) à fente unique (105a) dont ladite fente unique (105a) s'étend le long d'un tronçon de l'élément allongé présent dans la cavité du boîtier (101) lorsque l'élément allongé traverse l'orifice d'entrée (102) et l'orifice de sortie (103),
- une antenne (105) à double fentes (105a, 105b) dont une première fente (105) s'étend le long d'un tronçon de l'élément allongé (1) présent dans la cavité du boîtier (101) lorsque l'élément allongé traverse l'orifice d'entrée (102) et l'orifice de sortie (103), et dont une deuxième fente (105b) est sensiblement perpendiculaire à la première fente (105a), lesdites première et deuxième fentes (105a, 150b) étant incluses dans un même plan et comprenant une partie commune au niveau de leur intersection,
- une antenne (105) boucle.

4. Dispositif selon l'une des revendications précédentes, **caractérisé en ce que** le système d'isolement (106) comporte une première ferrite (106a) disposée au niveau de l'orifice d'entrée (102) et une deuxième ferrite (106b) disposée au niveau de l'orifice de sortie (103).

5. Installation (1000) comprenant un dispositif de traitement (100) selon l'une quelconque des revendications précédentes, un élément allongé (1) comportant une pluralité de puces électroniques (2a, 2b, 2c, 2d) échelonnées selon la longueur dudit élément allongé (1), un système d'entrainement (1001) de l'élément allongé (1) pour le faire défiler au travers du boîtier (101) du dispositif de traitement (101) par les orifices d'entrée et de sortie (102, 103), l'installation comprenant une configuration de traitement dans laquelle une puce électronique à traiter (2e) de l'élément allongé (1) est présente dans la cavité (104) du boîtier (101) et dans laquelle deux puces électroniques adjacentes (2f, 2g) à la puce électronique à traiter (2e) sont disposées hors du boîtier (101).

6. Installation selon la revendication précédente, **caractérisée en ce que** dans la configuration de traitement, les deux puces électroniques adjacentes (2f, 2g) à la puce électronique à traiter (2e) sont reliées électriquement à la puce à traiter (2e) par des éléments de liaison (3a, 3b) de l'élément allongé (1), et **en ce que** le système d'isolement (106) est configuré pour agir sur les ondes électromagnétiques issues de la sonde de traitement (105) se propageant le long desdits éléments de liaison (3a, 3b) reliés à ladite puce électronique à traiter (2e).

7. Installation selon la revendication précédente, **caractérisée en ce que** dans la configuration de traitement, lesdits éléments de liaison (3a, 3b) traversent chacun une ferrite (106a, 106b).

8. Installation selon la revendication 6 ou 7, **caractérisée en ce que** lesdits éléments de liaison (3a, 3b) sont en contact physique avec des éléments de mise en court-circuit du système d'isolement (106).

9. Procédé d'utilisation d'un dispositif selon l'une quelconque des revendications 1 à 4 comprenant :
- une étape de fourniture d'un élément allongé (1) comportant une pluralité de puces électroniques (2a, 2b, 2c, 2d) échelonnées selon la longueur dudit élément allongé (1),
- une étape de placement de l'une (2e) des puces de la pluralité de puces électroniques dans la cavité (104) du dispositif de traitement (101) de telle sorte que deux autres puces électroniques adjacentes (2f, 2g) de la puce électronique (2e) placée dans la cavité (104) soient disposées à l'extérieur du boîtier (101),
- une étape d'activation de la sonde de traitement (105) pour traiter ladite puce électronique (2e) placée dans la cavité (104) d'où il résulte que la sonde de traitement (105) interagit avec la puce électronique (2e) placée dans la cavité (104),
**caractérisé en ce que** la puce électronique (2e) placée dans la cavité (104) et les deux puces électroniques adjacentes (2f, 2g) placées hors du boîtier (101) au cours de l'étape de placement sont des puces électroniques de radio-étiquettes, et **en ce que** la puce électronique (2e) placée dans la cavité (104) est reliée électriquement à l'une des puces électroniques adjacentes (2f) par un premier élément de liaison électrique (3a), et à l'autre des puces électroniques adjacentes (2g) par un deuxième élément de liaison électrique (3b), les premier et deuxième éléments de liaison électrique (3a, 3b) formant une antenne de la puce électronique (2e) placée dans la cavité (104), et **en ce que** le procédé comporte une étape d'interaction du système d'isolement (106) avec les premier et deuxième éléments de liaison électrique (3a, 3b) permettant de filtrer, ou de court-circuiter, des ondes électromagnétiques se propageant long des premier et deuxième éléments de liaison électrique (3a, 3b) consécutivement à l'activation de la sonde de traitement pour éviter l'alimentation électrique desdites deux puces électroniques adjacentes par lesdites ondes électromagnétiques.

## Patentansprüche

1. Behandlungsvorrichtung (100), welche dafür geeignet ist, mit einem länglichen Element (1) zusammenzuwirken, das mit einer Vielzahl von elektronischen Chips (2a, 2b, 2c, 2d) ausgestattet ist, die entlang der Länge des länglichen Elements (1) verteilt sind, wobei die Behandlungsvorrichtung (100) ein Gehäuse (101) umfasst, umfassend:
- eine Eintrittsöffnung (102) für das längliche Element (1),
- eine Austrittsöffnung (103) für das längliche Element (1),
- einen Behandlungshohlraum (104), der zwischen der Eintrittsöffnung (102) und der Austrittsöffnung (103) angeordnet ist und mit einer Behandlungssonde (105) für elektronische Chips ausgestattet ist,
und wobei die Behandlungsvorrichtung ein Isoliersystem (106) umfasst, das dafür ausgelegt ist, einen zu behandelnden elektronischen Chip, der in dem Hohlraum (104) vorhanden ist, gegen andere elektronische Chips von der Vielzahl von elektronischen Chips zu isolieren, die an der Außenseite des Hohlraums (104) angeordnet sind, wobei dieses Isoliersystem (106) Kurzschlusselemente (106c, 106d) umfasst, die derart ausgelegt sind, dass sie in physikalischen Kontakt mit dem länglichen Element (1) auf beiden Seiten eines zu behandelnden Chips gelangen, der in den Hohlraum (104) platziert ist.

2. Vorrichtung nach dem vorhergehenden Anspruch, **dadurch gekennzeichnet, dass** die Behandlungssonde (105) eine Hochfrequenzantenne umfasst, die dafür ausgelegt ist, mit dem zu behandelnden elektronischen Chip zu interagieren, der einen Funkchip bildet.

3. Vorrichtung nach dem vorhergehenden Anspruch, **dadurch gekennzeichnet, dass** die Antenne ausgewählt ist aus :
- einer dipolaren Antenne (105),
- einer Antenne (105) mit einem Einzelschlitz (105a), wobei sich der Einzelschlitz (105a) entlang eines Abschnitts des länglichen Elements erstreckt, das in dem Hohlraum des Gehäuses (101) vorhanden ist, wenn das längliche Element die Eintrittsöffnung (102) und die Austrittsöffnung (103) durchquert,
- einer Antenne (105) mit einem Doppelschlitz (105a, 105b), wobei sich ein erster Schlitz (105) entlang eines Abschnitts des länglichen Elements (1) erstreckt, das in dem Hohlraum des Gehäuses (101) vorhanden ist, wenn das längliche Element die Eintrittsöffnung (102) und die Austrittsöffnung (103) durchquert, und wobei ein zweiter Schlitz (105b) im Wesentlichen rechtwinklig zu dem ersten Schlitz (105a) ist, wobei der erste und zweite Schlitz (105a, 105b) in derselben Ebene enthalten sind und einen gemeinsamen Teil auf der Höhe ihrer Kreuzung umfassen,
- einer Schleifenantenne (105).

4. Vorrichtung nach einem der vorhergehenden Ansprüche, **dadurch gekennzeichnet, dass** das Isoliersystem (106) einen ersten Ferrit (106a), der auf der Höhe der Eintrittsöffnung (102) angeordnet ist, und einen zweiten Ferrit (106b), der auf der Höhe der Austrittsöffnung (103) angeordnet ist, umfasst.

5. Anlage (1000), umfassend eine Behandlungsvorrichtung (100) nach einem der vorhergehenden Ansprüche, ein längliches Element (1), das eine Vielzahl von elektronischen Chips (2a, 2b, 2c, 2d) umfasst, die entlang der Länge des länglichen Elements (1) verteilt sind, ein Antriebssystem (1001) des länglichen Elements (1), um es quer durch das Gehäuse (101) der Behandlungsvorrichtung (101) durch die Eintritts- und Austrittsöffnung (102, 103) hindurchgehen zu lassen, wobei die Anlage eine Behandlungsauslegung umfasst, in der ein zu behandelnder elektronischer Chip (2e) des länglichen Elements (1) in dem Hohlraum (104) des Gehäuses (101) vorhanden ist, und in der zwei elektronische Chips (2f, 2g), die dem zu behandelnden elektronischen Chip (2e) benachbart sind, außerhalb des Gehäuses (101) angeordnet sind.

6. Anlage nach dem vorhergehenden Anspruch, **dadurch gekennzeichnet, dass** in der Behandlungsauslegung die beiden elektronischen Chips (2f, 2g), die dem zu behandelnden elektronischen Chip (2e) benachbart sind, elektrisch mit dem zu behandelnden elektronischen Chip (2e) durch Verbindungselemente (3a, 3b) des länglichen Elements (1) verbunden sind, und dadurch, dass das Isoliersystem (106) dafür ausgelegt ist, auf die von der Behandlungssonde (105) ausgesendeten elektromagnetischen Wellen einzuwirken, die sich entlang der Verbindungselemente (3a, 3b) ausbreiten, welche mit dem zu behandelnden elektronischen Chip (2e) verbunden sind.

7. Anlage nach dem vorhergehenden Anspruch, **dadurch gekennzeichnet, dass** in der Behandlungsauslegung die Verbindungselemente (3a, 3b) jeweils einen Ferrit (106a, 106b) durchqueren.

8. Anlage nach Anspruch 6 oder 7, **dadurch gekennzeichnet, dass** die Verbindungselemente (3a, 3b) in physikalischem Kontakt mit den Kurzschlusselementen des Isoliersystems (106) stehen.

9. Verfahren zur Verwendung einer Vorrichtung nach einem der Ansprüche 1 bis 4, umfassend:
- einen Schritt des Bereitstellens eines länglichen Elements (1), das eine Vielzahl von elektronischen Chips (2a, 2b, 2c, 2d) umfasst, die entlang der Länge des länglichen Elements (1) verteilt sind,
- einen Schritt des Platzierens des einen (2e) der Chips von der Vielzahl von elektronischen Chips in den Hohlraum (104) der Behandlungsvorrichtung (101) derart, dass zwei andere elektronische Chips (2f, 2g), die dem elektronischen Chip (2e) benachbart sind, der in den Hohlraum (104) platziert wird, an der Außenseite des Gehäuses (101) angeordnet werden,
- einen Schritt des Aktivierens der Behandlungssonde (105), um den elektronischen Chip (2e) zu behandeln, der in den Hohlraum (104) platziert wird, was dazu führt, dass die Behandlungssonde (105) mit dem elektronischen Chip (2e) interagiert, der in den Hohlraum (104) platziert wird,
**dadurch gekennzeichnet, dass** der elektronische Chip (2e), der in den Hohlraum (104) platziert wird, und die beiden benachbarten elektronischen Chips (2f, 2g), die während des Platzierungsschritts außerhalb des Gehäuses (101) platziert werden, elektronische Funkchips sind, und dadurch, dass der elektronische Chip (2e), der in den Hohlraum (104) platziert wird, elektrisch mit dem einem der benachbarten elektronischen Chips (2f) durch ein erstes elektrisches Verbindungselement (3a) verbunden wird, und mit dem anderen der benachbarten elektronischen Chips (2g) durch ein zweites elektrisches Verbindungselement (3b), wobei das erste und zweite elektrische Verbindungselement (3a, 3b) eine Antenne des elektronischen Chips (2e) bilden, der in den Hohlraum (104) platziert wird, und dadurch, dass das Verfahren einen Schritt des Interagierens des Isoliersystems (106) mit dem ersten und zweiten elektrischen Verbindungselement (3a, 3b) umfasst, der es gestattet, elektromagnetische Wellen zu filtern oder kurzzuschließen, die sich entlang des ersten und zweiten elektrischen Verbindungselements (3a, 3b) nach der Aktivierung der Behandlungssonde ausbreiten, um die elektrische Versorgung der beiden benachbarten elektronischen Chips mit den elektromagnetischen Wellen zu vermeiden.

## Claims

1. A treatment device (100) capable of cooperating with an elongate element (1) provided with a plurality of electronic chips (2a, 2b, 2c, 2d) staggered along the length of said elongate element (1), said treatment device (100) comprising a housing (101) comprising:
- an input orifice (102) for the elongate element (1),
- an output orifice (103) for the elongate element (1),
- a treatment cavity (104) arranged between the input orifice (102) and the output orifice (103) and provided with a treatment probe (105) for electronic chips,
and the treatment device comprising an isolation system (106) configured to isolate an electronic chip to be treated and being in the cavity (104) from other electronic chips of the plurality of electronic chips arranged outside the cavity (104), this isolation system (106) comprising short-circuiting elements (106c, 106d) configured to come into physical contact with the elongate element (1) on either side of a chip to be treated placed in the cavity (104).

2. The device as claimed in the preceding claim, **characterized in that** the treatment probe (105) comprises a radiofrequency antenna configured to interact with the electronic chip to be treated forming a chip of a radio-tag.

3. The device as claimed in the preceding claim, **characterized in that** the antenna is chosen from among:
- a dipole antenna (105),
- an antenna (105) with single slot (105a) of which said single slot (105a) extends along a section of the elongate element present in the cavity of the housing (101) when the elongate element passes through the input orifice (102) and the output orifice (103),
- an antenna (105) with double slots (105a, 105b) of which a first slot (105) extends along a section of the elongate element (1) present in the cavity of the housing (101) when the elongate element passes through the input orifice (102) and the output orifice (103), and of which a second slot (105b) is substantially at right angles to the first slot (105a), said first and second slots (105a, 150b) being included in one and the same plane and comprising a common part at their intersection,
- a loop antenna (105).

4. The device as claimed in one of the preceding claims, **characterized in that** the isolation system (106) comprises a first ferrite (106a) arranged at the input orifice (102) and a second ferrite (106b) arranged at the output orifice (103).

5. An installation (1000) comprising a treatment device (100) as claimed in any one of the preceding claims, an elongate element (1) comprising a plurality of electronic chips (2a, 2b, 2c, 2d) staggered along the length of said elongate element (1), a system (1001) for driving the elongate element (1) to run it through the housing (101) of the treatment device (101) through the input and output orifices (102, 103), the installation comprising a treatment configuration in which an electronic chip to be treated (2e) of the elongate element (1) is in the cavity (104) of the housing (101) and in which two electronic chips (2f, 2g) adjacent to the electronic chip to be treated (2e) are arranged outside of the housing (101).

6. The installation as claimed in the preceding claim, **characterized in that**, in the treatment configuration, the two electronic chips (2f, 2g) adjacent to the electronic chip to be treated (2e) are linked electrically to the chip to be treated (2e) by link elements (3a, 3b) of the elongate element (1), and **in that** the isolation system (106) is configured to act on the electromagnetic waves from the treatment probe (105) that are propagated along said link elements (3a, 3b) linked to said electronic chip to be treated (2e).

7. The installation as claimed in the preceding claim, **characterized in that**, in the treatment configuration, said link elements (3a, 3b) each pass through a ferrite (106a, 106b).

8. The installation as claimed in claim 6 or 7, **characterized in that** said link elements (3a, 3b) are in physical contact with short-circuiting elements of the isolation system (106).

9. A method for using a device as claimed in any one of claims 1 to 4, comprising:
- a step of provision of an elongate element (1) comprising a plurality of electronic chips (2a, 2b, 2c, 2d) staggered along the length of said elongate element (1),
- a step of placement of one (2e) of the chips of the plurality of electronic chips in the cavity (104) of the treatment device (101) such that two other electronic chips (2f, 2g) adjacent to the electronic chip (2e) placed in the cavity (104) are arranged outside of the housing (101),
- a step of activation of the treatment probe (105) to treat said electronic chip (2e) placed in the cavity (104), the result of which is that the treatment probe (105) interacts with the electronic chip (2e) placed in the cavity (104),
**characterized in that** the electronic chip (2e) placed in the cavity (104) and the two adjacent electronic chips (2f, 2g) placed outside of the housing (101) during the step of placement are electronic chips of radio-tags, and **in that** the electronic chip (2e) placed in the cavity (104) is linked electrically to one of the adjacent electronic chips (2f) by a first electrical link element (3a), and to the other of the adjacent electronic chips (2g) by a second electrical link element (3b), the first and second electrical link elements (3a, 3b) forming an antenna of the electronic chip (2e) placed in the cavity (104), and **in that** the method comprises a step of interaction of the isolation system (106) with the first and second electrical link elements (3a, 3b) making it possible to filter, or short-circuit, electromagnetic waves that are propagated along the first and second electrical link elements (3a, 3b) following the activation of the treatment probe to avoid electrically powering said two adjacent electronic chips by said electromagnetic waves.
